# EUROPÄISCHE PATENTANMELDUNG

(11) **EP 1 566 833 A2**
(43) Veröffentlichungstag der Anmeldung: **24.08.2005**
(21) Anmeldenummer: 05003211.9
(22) Anmeldetag: 16.02.2005
(51) Int. Cl.: H01L 21/20, C30B 29/60

(54) **Verfahren zur Integration von kolloidal erzeugten Nanopartikeln in epitaktische Schichten**

(30) Priorität: 19.02.2004 DE 102004008065
(71) Anmelder: Schikora, Detlef, Prof. Dr., 37688 Wehrden (DE); Artemyev, Mikhail V., Minsk 220086 (BY); Herz, Erik, Ithaca, NY 14850 (US); Lischka, Klaus, Prof. Dr., 33098 Paderborn (DE); Woggon, Ulrike, Prof. Dr., 44229 Dortmund (DE)
(72) Erfinder: Schikora, Detlef, Prof. Dr., 37688 Wehrden (DE); Artemyev, Mikhail V., Minsk 220086 (BY); Herz, Erik, Ithaca, NY 14850 (US); Lischka, Klaus, Prof. Dr., 33098 Paderborn (DE); Woggon, Ulrike, Prof. Dr., 44229 Dortmund (DE)
(74) Vertreter: Lorenz, Werner

(57) **Zusammenfassung**

Bei einem Verfahren zur Integration von kolloidal erzeugten Nanopartikeln (6) in epitaktischen Schichten (8) werden die Nanopartikel (6) in eine Trägerlösung (5) eingebracht. Die Trägerlösung (5) wird auf die Oberfläche (4) einer ersten epitaktischen Schicht (3) aufgebracht und auf derselben verdampft, wodurch sich die Nanopartikel (6) auf der Oberfläche (4) der ersten epitaktischen Schicht (3) isoliert voneinander anlagern. Die Nanopartikel (6) werden anschließend mittels einer zweiten epitaktischen Schicht (8) überwachsen.

## Beschreibung

Die Erfindung betrifft ein Verfahren zur Integration von kolloidal erzeugten Nanopartikeln in epitaktischen Schichten.

Aus der DE 197 26 989 A1 ist ein Verfahren zur Herstellung von Quantenpunkten aus der Gruppe der III/V-Verbindungshalbleiter im Stranski-Krastanow Wachstumsmodus mittels MOCVD bekannt. Mit diesem bekannten Verfahren sollen defektfreie Quantenpunktensembles mit lateralen Dichten von mehr als 10¹¹ cm² auf orientierten Substraten hergestellt werden.

Der Wachstumsmodus nach Stranski-Krastanow ist ein von der Natur selbst organisierter Prozess, in den nur in äußerst geringem Umfang eingegriffen werden kann. Dies hat insbesondere im Hinblick auf die mit einem solchen Verfahren erzielbaren Variationen der Größe der Nanopartikel sowie deren Flächendichte Auswirkungen, so dass lediglich über die Variation des verwendeten Materials eine Variation der Größe der Nanopartikel sowie deren Flächendichte erreicht werden kann.

Aus der DE 197 10 685 A1 ist ein nanokristalline Partikel enthaltendes Material und ein Verfahren zu dessen Herstellung bekannt, bei welchem ein nanokristalline Partikel und stabilisierende Liganden enthaltendes Sol hergestellt wird, welches direkt auf ein Substrat aufgebracht und anschließend ausgehärtet wird.

Die DE 100 44 040 A1 beschreibt ein Verfahren zur Verbesserung der Effizienz von epitaktisch hergestellten Quantenpunkt-Halbleiterbauelementen mit einer oder mehreren Quantenpunktschichten.

Die Herstellung von Nanopartikeln bzw. Nanokristallen, die auch als Quantendots bezeichnet werden, ist beispielsweise aus der US 5,614,435 bekannt.

Sämtliche der bekannten Verfahren stellen sich nicht die Aufgabe bzw. sind nicht in der Lage, die oben genannten Nachteile bezüglich der Variation von Größe und Flächendichte der Nanopartikel zu eliminieren.

Es ist daher Aufgabe der vorliegenden Erfindung, ein Verfahren zur Integration von kolloidal erzeugten Nanopartikeln in epitaktischen Schichten zu schaffen, welches es ermöglicht, verschiedene Parameter bezüglich der Verteilung der Nanopartikel in der epitaktischen Schichtstruktur, insbesondere die Größe der einzelnen Nanopartikel sowie deren Flächendichte, zu variieren.

Erfindungsgemäß wird diese Aufgabe durch die in Anspruch 1 genannten Merkmale gelöst.

Durch das erfindungsgemäße Einbringen der Nanopartikel in die Trägerlösung ist es möglich, die Anzahl der auf die Oberfläche der ersten epitaktischen Schicht aufgebrachten Nanopartikel mittels geeignetem Verdünnen der Trägerlösung mit einer sehr hohen Genauigkeit einzustellen. Dieses Verdünnen der Trägerlösung kann sogar derart durchgeführt werden, dass sich in der Trägerlösung und somit anschließend auf der epitaktischen Schicht einzelne Nanopartikel befinden.

Aufgrund der kolloidalen bzw. chemischen Erzeugung der Nanopartikel ist es darüber hinaus möglich, Nanopartikel mit einer bestimmten Größe in die Trägerlösung zu geben, so dass die in der bei dem erfindungsgemäßen Verfahren entstehenden Schichtstruktur enthaltenen Nanopartikel exakt die gewünschte Größe aufweisen.

Durch das erfindungsgemäße Verfahren werden ansonsten vorhandene Keimbildungsprozesse im epitaktischen Wachstum vermieden, wodurch sich eine Unabhängigkeit von thermodynamischen Gleichgewichtsbedingungen ergibt, die bei üblichen epitaktischen Wachstumsprozessen die Dichte und die Verteilung der Nanopartikel sowie deren Anfangsgröße bestimmen. Auf diese Weise lässt sich also der bislang bestehende Nachteil des selbstorganisierten Wachstums der Nanopartikel vermeiden und es können vorteilhafterweise geordnete Strukturen erzeugt werden.

Dadurch, dass die Trägerlösung von der epitaktischen Schicht verdampft wird, ist sichergestellt, dass sich auf derselben lediglich die Nanopartikel befinden und nach dem anschließenden Überwachsen mittels der zweiten epitaktischen Schicht vor einer eventuellen Agglomeration, Oxidation oder sonstigen negativen Effekten geschützt werden.

Des weiteren können all diejenigen Effekte, die durch bei kolloidalen Nanopartikeln benutzten oberflächenstabilisierenden Molekülgruppen hervorgerufen werden, wie photochemische Degradation und ähnliches, ausgeschlossen werden, sodass sich insgesamt eine für die verschiedensten Anwendungszwecke geeignete epitaktische Schichtstruktur ergibt.

In einer vorteilhaften Weiterbildung der Erfindung kann vorgesehen sein, dass die Nanopartikel vollständig mittels der zweiten epitaktischen Schicht überwachsen werden. Auf diese Weise werden sämtliche auf die erste epitaktische Schicht aufgebrachten Nanopartikel mittels der zweiten epitaktischen Schicht geschützt.

Alternativ ist es auch möglich, die Nanopartikel nur teilweise mittels der zweiten epitaktischen Schicht zu überwachsen. Dadurch lässt sich eine gewisse Strukturierung der auf der ersten epitaktischen Oberfläche aufgebrachten Nanopartikel erreichen, da lediglich diejenigen Nanopartikel funktionsfähig sind, die mittels der zweiten epitaktischen Schicht überwachsen wurden.

Wenn eine Trägerlösung mit einer derartigen Dichte und Viskosität verwendet wird, dass die Nanopartikel isoliert voneinander in einem schwebenden Zustand gehalten werden, so kann die in die Trägerlösung eingebrachte Verteilung der Nanopartikel konstant gehalten werden, da auf diese Weise verhindert wird, dass sich einzelne Nanopartikel zusammenschließen können, was zu einer Verschlechterung des Ergebnisses führen könnte.

Des weiteren kann vorgesehen sein, dass eine Trägerlösung verwendet wird, die die Oberfläche der epitaktischen Schicht vollständig benetzt. Dies führt vorteilhafter Weise zu einer Verteilung der Nanopartikel auf der gesamten Oberfläche der ersten epitaktischen Schicht.

Eine Verbesserung der Reinheit der mittels des erfindungsgemäßen Verfahrens erzeugten epitaktischen Schichtstruktur wird erreicht, wenn eine Trägerlösung verwendet wird, welche eine derartige chemische Reinheit und einen derartigen Dampfdruck aufweist, dass die Trägerlösung rückstandsfrei von der Oberfläche der epitaktischen Schicht verdampft.

Ein elektronisches Bauelement mit einer nach einem der Ansprüche 1 bis 32 hergestellten epitaktischen Schichtstruktur ist Anspruch 33 zu entnehmen.

Weitere vorteilhafte Ausgestaltungen und Weiterbildungen der Erfindung ergeben sich aus den restlichen Unteransprüchen. Nachfolgend sind Ausführungsbeispiele der Erfindung anhand der Zeichnung prinzipmäßig dargestellt.

Es zeigt:
- Fig. 1: einen ersten Schritt des erfindungsgemäßen Verfahrens zur Integration von kolloidal erzeugten Nanopartikeln in epitaktischen Schichten;
- Fig. 2: einen zweiten Schritt des Verfahrens gemäß Fig. 1;
- Fig. 3: eine Alternative des zweiten Schritts des Verfahrens aus Fig. 1;
- Fig. 4: eine Alternative des ersten Schritts des erfindungsgemäßen Verfahrens;
- Fig. 5: eine weitere Alternative des ersten Schritts des erfindungsgemäßen Verfahrens; und
- Fig. 6: eine weitere Ausführungsform des erfindungsgemäßen Verfahrens.

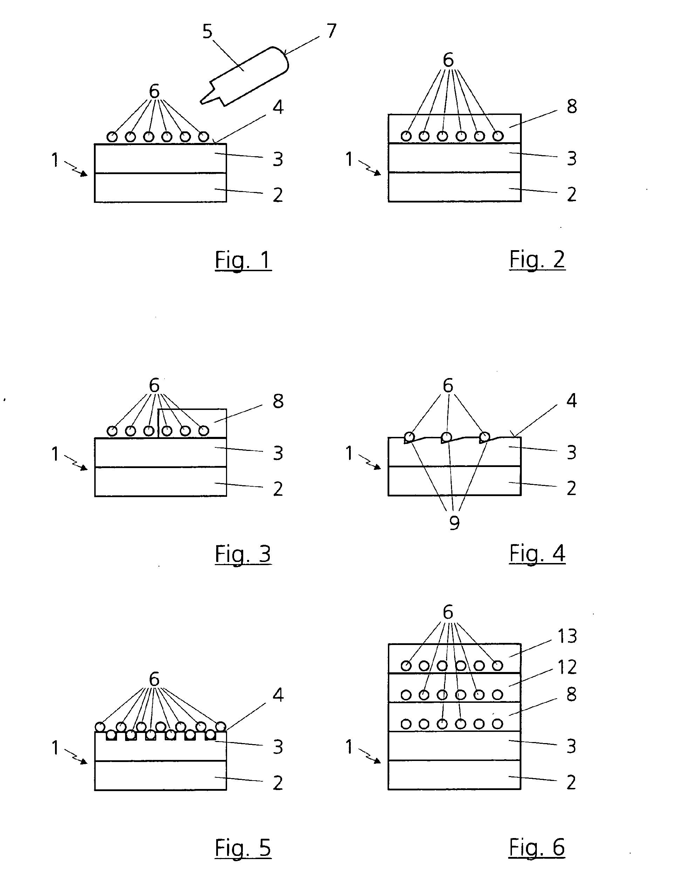

Fig. 1 zeigt eine Schichtstruktur 1, welche als unterste Schicht ein Substrat 2 aufweist, welches beispielsweise aus Galliumarsenit (GaAs) bestehen kann. Auf das Substrat 2 wird mittels eines epitaktischen Verfahrens eine erste epitaktische Schicht 3 aufgebracht, welche beispielsweise aus Zinkselenit (ZnSe) bestehen kann. Die Dicke der ersten epitaktischen Schicht 3 kann beispielsweise 1 µm betragen.

Auf die Oberfläche 4 der ersten epitaktischen Schicht 3 werden in einer Trägerlösung 5 enthaltene Nanopartikel 6 aufgebracht. Im vorliegenden Fall befindet sich die Trägerlösung 5 in einem Behälter 7 und wird durch Auftropfen auf die Oberfläche 4 der ersten epitaktischen Schicht 3 aufgebracht. Alternativ wäre auch ein Aufbringen der Trägerlösung 5 durch Spinnen oder durch Aufsprühen auf die Oberfläche 4 der ersten epitaktischen Schicht 3 möglich. Beim Spinnen wird die erste epitaktische Schicht 3 bzw. die gesamte bis dahin entstandene Schichtstruktur 1 in Rotation versetzt, so dass die Trägerlösung 5 durch die dabei entstehenden Fliehkräfte über die gesamte Oberfläche 4 verteilt werden.

Bei den Nanopartikeln 6 handelt es sich um kolloidal, also chemisch hergestellte Nanopartikel 6, die in die Trägerlösung 5 eingebracht und dort auf die gewünschte Dichte verdünnt werden können. In diesem Zusammenhang ist zu bevorzugen, wenn in die Trägerlösung 5 1 bis 10¹⁵ Nanopartikel 6 pro cm³ der Trägerlösung 5 eingebracht werden, was bei kolloidal hergestellten Nanopartikeln 6 relativ problemlos möglich ist. Vorzugsweise werden Nanopartikel 6 aus einem halbleitenden, einem metallischen oder einem nichtleitenden Material verwendet. Wenn die Nanopartikel 6 aus einem halbleitenden Material bestehen, so ist es besonders vorteilhaft, wenn diese aus Silizium, Germanium, A3-B5, A2-B6 oder A4-B6-Verbindungshalbleitern bestehen. Typische Vertreter von A3-B5-Verbindungshalbleitern sind Galliumarsenit und Indiumarsenit; von A2-B6-Verbindungshalbleitern Zinkselenit und Kadmiumselenit und von A4-B6-Verbindungshalbleitern Zinktellurit und Bleitellurit.

Die morphologische Form der Nanopartikel 6 kann kugelförmig, stabförmig und/oder pyramidal sein, d.h. es ist auch möglich, in ein und derselben Trägerlösung 5 Nanopartikel 6 mit unterschiedlicher morphologischer Form einzusetzen. Des weiteren ist es möglich, Nanopartikel 6 mit einer kubischen, hexagonalen, tetragonalen, rhombischen und/oder monoklinen Kristallstruktur zu verwenden, wobei auch hier Mischungen möglich sind. Es ist insbesondere auch möglich, eine annähernd beliebige Mischung der Nanopartikel 6 aus unterschiedlichen Materialien, mit unterschiedlichen morphologischen Formen und mit unterschiedlichen Kristallstrukturen zu verwenden.

Nach dem Aufbringen der Trägerlösung 5 auf die Oberfläche 4 der ersten epitaktischen Schicht 3 wird die Trägerlösung 5 von der Oberfläche 4 verdampft, wobei hier vorzugsweise eine Trägerlösung 5 verwendet wird, welche eine derartige chemische Reinheit und einen derartigen Dampfdruck aufweist, dass die Trägerlösung 5 rückstandsfrei von der Oberfläche 4 der ersten epitaktischen Schicht 3 verdampft. Als geeignet für die Trägerlösung 5 haben sich hierbei vor allem Alkohole, insbesondere Methanol, sowie Pyridin erwiesen, es ist aber durchaus denkbar, dass auch andere Flüssigkeiten als Trägerlösung 5 verwendbar sind. Eine Möglichkeit zur Aufbringung der Trägerlösung 5 auf der Oberfläche 4 der ersten epitaktischen Schicht 3 besteht beispielsweise darin, diese in reiner Stickstoffatmosphäre aufzubringen, um die Kontamination der Oberfläche 4 mit Sauerstoff zu verhindern.

Ein weiteres Kriterium zur Auswahl der Trägerlösung 5 besteht darin, dass sie in der Lage sein sollte, die Oberfläche 4 der ersten epitaktischen Schicht 3 vollständig zu benetzen, und dass sie eine derartige Dichte und Viskosität aufweisen, dass die Nanopartikel 6 isoliert voneinander in einem schwebenden Zustand in der Trägerlösung 5 gehalten werden. Dies wird beispielsweise dadurch erreicht, dass die Trägerlösung 5 eine ähnliche Dichte wie die Nanopartikel 6 aufweist.

Nach dem Verdampfen der Trägerlösung 5 lagern sich die Nanopartikel 6 isoliert voneinander auf der Oberfläche 4 der ersten epitaktischen Schicht 3 ab. Wie in Fig. 2 erkennbar, werden die Nanopartikel 6 anschließend mittels einer zweiten epitaktischen Schicht 8 überwachsen, d.h. die Nanopartikel 6 werden in die zweite epitaktische Schicht 8, die sich unmittelbar an die erste epitaktische Schicht 3 anschließt, integriert, so dass die Nanopartikel 6 Teil der durch das beschriebene Verfahren erzeugten Schichtstruktur 1 sind. Bei der Ausführungsform gemäß Fig. 2 findet eine vollständige Überwachsung der Nanopartikel 6 mittels der zweiten epitaktischen Schicht 8 statt.

Alternativ ist es auch möglich, die Nanopartikel 6 mittels der zweiten epitaktischen Schicht 8 nur teilweise zu überwachsen, wie in Fig. 3 dargestellt. Hierzu kann nach dem Aufbringen der Trägerlösung 5 auf die Oberfläche 4 der ersten epitaktischen Schicht 3 eine beispielsweise aus Metall bestehende Maske aufgelegt werden, die eine Verbindung der zweiten epitaktischen Schicht 8 mit der ersten epitaktischen Schicht 3 verhindert.

Durch den Schritt des Einbringens der Nanopartikel 6 in die Trägerlösung 5 ist es möglich, die Trägerlösung 5 derart zu verdünnen, dass sich auf der Oberfläche 4 der ersten epitaktischen Schicht 3 eine gewünschte Anzahl an Nanopartikeln 6 befindet. Mit anderen Worten, es ist auf diese Weise möglich, die Flächendichte der Nanopartikel 6 in der gewünschten Weise einzustellen.

Es ist möglich, als Monomere, Dimere oder Trimere vorliegende Nanopartikel 6 zu verwenden. Je nach Anzahl der Monomere, Dimere oder Trimere werden die elektronischen Eigenschaften der zweiten epitaktischen Schicht 8 verändert, was zu jeweils unterschiedlichen Anwendungsmöglichkeiten führt.

Des weiteren ermöglicht die kolloidale Erzeugung der Nanopartikel 6 das Einbringen einer bestimmten Größe von Nanopartikeln 6 in die Trägerlösung 5. Die Nanopartikel 6 können mit einer mittleren Größe von 1 bis 1.000 nm (1 µm) verwendet werden. In ein und derselben Trägerlösung 5 können Nanopartikel 6 mit unterschiedlicher Größe enthalten sein, wobei die Größe der Nanopartikel 6 entscheidend dafür ist, welche Lichtwellenlänge sie emittieren.

Für die zweite epitaktische Schicht 8 kommen als Materialien Verbindungshalbleiter, wie Silizium, Germanium, A3-B5, A2-B6 oder A4-B6-Verbindungshalbleiter, metallische Elemente, Legierungen oder Mischkristalle oder auch nichtleitende, dielektrische Materialien in Frage. Für die Auswahl des Materials der zweiten epitaktischen Schicht 8 spielt vor allem der spätere Anwendungszweck der Schichtstruktur 1 eine entscheidende Rolle, wobei die Verwendung der mit einem der hierin beschriebenen Verfahren hergestellten Schichtstruktur 1 vor allem in einem elektronischen, insbesondere optoelektronischen, Bauelement besteht. Als optoelektronische Bauelemente kommen insbesondere Laser in Frage, da die Nanopartikel 6, wenn sie angeregt werden, eine sehr hohe Energiemenge abgeben.

Bei den in den Figuren 1 bis 3 dargestellten Verfahren wird die erste epitaktische Schicht 3 in Richtung niedrig indizierter kristallographischer Orientierungen gewachsen. Dadurch ergibt sich eine statistische Verteilung der Nanopartikel 6 auf der Oberfläche 4 der ersten epitaktischen Schicht 3. Durch die Orientierung der ersten epitaktischen Schicht 3 bzw. deren Art des Wachstums kann die Benetzung derselben beeinflusst werden.

In Fig. 4 ist eine Ausführungsform dargestellt, bei der die erste epitaktische Schicht 3 mit einer vicinalen Oberflächenorientierung mit einem Winkel von ca. 2 bis 10° gewachsen wird. Hierdurch ergibt sich eine Abstufung der Oberfläche 4 mit mehreren Stufen 9 und es besteht eine hohe Wahrscheinlichkeit, dass sich die Nanopartikel 6 an diesen Stufen 9 anlagern, wie dies auch in Fig. 3 dargestellt ist. Auf diese Weise können die Nanopartikel 6 auf der Oberfläche 4 geordnet werden.

Eine andere Möglichkeit zur Strukturierung der Oberfläche 4 der ersten epitaktischen Schicht 3 und somit zur Ordnung der Nanopartikel 6 ist in Fig. 5 dargestellt. Hierbei weist die Oberfläche 4 mehrere Vertiefungen 10 auf, die sich mit Erhöhungen 11 abwechseln.

Um die Nanopartikel 6 auf der Oberfläche 4 zu ordnen, wäre es auch möglich, in die erste epitaktische Schicht 3 wenigstens eine laterale Strukturierung mit einer charakteristischen Strukturierungslänge von 500 nm bis 5.000 nm einzubringen. Des weiteren könnte die erste epitaktische Schicht 3 auch mit einer definierten, durch ein Substrat mit abweichender Gitterkonstante aufgeprägten, hydrostatischen Verspannung erzeugt werden.

Auch die Wahl der atomaren Struktur der Oberfläche 4 der ersten epitaktischen Schicht 3 kann die Anordnung der Nanopartikel 6 auf derselben beeinflussen. Eine weitere Möglichkeit zur Strukturierung der Oberfläche 4 der ersten epitaktischen Schicht 3 besteht darin, lithographische Verfahren zu verwenden. Selbstverständlich ist auch eine Kombination der oben genannten Möglichkeiten denkbar.

Die Gitterkonstante der ersten epitaktischen Schicht 3 lässt sich beispielsweise dadurch verändern, dass in dieselbe eine bestimmte Anzahl von Atomen eines anderen Materials eingegeben wird, was zu einer veränderten atomaren Struktur der ersten epitaktischen Schicht 3 führt. Auch dies beeinflusst das Benetzungsverhalten der Oberfläche 4 der ersten epitaktischen Schicht 3.

Wenn in einer nicht dargestellten Ausführungsform des Verfahrens die Dichte der Nanopartikel 6 derart erhöht wird, dass ihr gegenseitiger Abstand im Bereich bzw. in der Größenordnung ihres eigenen Durchmessers liegt, so beginnen die Nanopartikel 6 sich gegenseitig zu ordnen mit dem Bestreben, eine Konstellation einzugehen, die ein energetisches Minimum darstellt. Auf diese Weise wird eine bestimmte Ordnung der Nanopartikel 6 erreicht. Um diesen Effekt zu erreichen, kann es erforderlich bzw. sinnvoll sein, die Nanopartikel 6 thermisch zu aktivieren. Eine weitere Möglichkeit zur Aktivierung der Nanopartikel 6 besteht auch in einer hydrostatischen Verspannung. Auch eine Kombination aus thermischer Aktivierung und hydrostatischer Verspannung ist möglich. Des weiteren ist es auch denkbar, die Position der Nanopartikel 6 in an sich bekannter Weise mit einem Raster-Tunnel-Mikroskop bzw. Raster-Sonden-Mikroskop zu verändern.

Fig. 6 zeigt eine Ausführungsform, bei der oberhalb der die Nanopartikel 6 enthaltenden zweiten epitaktischen Schicht 8 eine dritte epitaktische Schicht 12 und eine vierte epitaktische Schicht 13 vorgesehen sind, die jeweils ebenfalls Nanopartikel 6 enthalten. Hierbei werden die zweite epitaktische Schicht 12 und die vierte epitaktische Schicht 13 wie die erste epitaktische Schicht 3 und die zweite epitaktische Schicht 8 in an sich bekannter Weise in einem Dünnschichtverfahren unter Ultrahochvakuum aufgebracht.

Selbstverständlich können die epitaktischen Schichten 8, 12 und 13 aus unterschiedlichen Materialien bestehen und/oder unterschiedliche Dicken aufweisen. Wenn sich die Dicke der Schichten 8, 12 und 13 unterhalb einer bestimmten Dicke befindet, so ist zu erwarten, dass sich die Nanopartikel 6 in der jeweils darüber liegenden Schicht nach der Ausrichtung der Nanopartikel 6 in der jeweils darunter liegenden Schicht ausrichten. Dies führt bei der Beaufschlagung der Nanopartikel 6 zu Verstärkungs- bzw. Resonanzeffekten, die bei bestimmten Anwendungen sinnvoll genutzt werden können.

Insbesondere wenn die Nanopartikel 6 aus demselben Material wie die zweite epitaktische Schicht 8 bestehen, kann es sinnvoll sein, zumindest einen Teil der Nanopartikel 6 mit einem andersartigen Atom oder Ion zu dotieren, mit dem Ergebnis, dass sich in einer vollständig homogenen zweiten epitaktischen Schicht 8 einzelne Atome bzw. Ionen desjenigen Materials befinden, mit dem die Nanopartikel 6 dotiert wurden. Auf diese Weise werden die Nanopartikel 6 als Träger für die einzelnen Atome verwendet. Elektronische Bauelemente, die derartige Schichtstrukturen 1 beinhalten, können vor allem in der Mikroelektronik eingesetzt werden.

Wenn die Nanopartikel 6 dieselbe chemische Zusammensetzung und eine andere Kristallstruktur wie die zweite epitaktische Schicht 8 aufweisen, so ist es möglich, eine zwar chemisch einheitliche Schicht 8 zu erhalten, die jedoch in unterschiedlichen Bereichen unterschiedliche elektronische Eigenschaften aufgrund der veränderten Kristallstruktur aufweisen. Ähnliche Effekte können erzielt werden, wenn die Nanopartikel 6 eine andere chemische Zusammensetzung und dieselbe Kristallstruktur wie die zweite epitaktische Schicht 8 aufweisen.

Insbesondere wenn die Nanopartikel 6 aus einem ähnlichen, jedoch unterschiedlichen Material wie die zweite epitaktische Schicht 8 bestehen, kann es zu technisch interessanten Anwendungen kommen, da hier jeweils bestimmte Unterschiede bezüglich des Brechungsindex bestehen. Dies bedeutet, dass es zu bevorzugen ist, wenn die Materialien der Nanopartikel 6 in der zweiten epitaktischen Schicht 8 jeweils Legierungen sind, deren Elemente in denselben Haupt- bzw. Nebengruppen zu finden sind.

Eine weitere technische Anwendung entsteht, wenn die Nanopartikel 6 aus einem Metall und die zweite epitaktische Schicht 8 aus einem Dielektrikum bestehen.

## Patentansprüche

1. Verfahren zur Integration von kolloidal erzeugten Nanopartikeln in epitaktischen Schichten,
**dadurch gekennzeichnet, dass**
die Nanopartikel (6) in eine Trägerlösung (5) eingebracht werden, dass die Trägerlösung (5) auf die Oberfläche (4) einer ersten epitaktischen Schicht (3) aufgebracht und auf derselben verdampft wird, wodurch sich die Nanopartikel (6) auf der Oberfläche (4) der ersten epitaktischen Schicht (3) isoliert voneinander anlagern, und dass die Nanopartikel (6) anschließend mittels einer zweiten epitaktischen Schicht (8) überwachsen werden.

2. Verfahren nach Anspruch 1,
**dadurch gekennzeichnet, dass**
die Nanopartikel (6) vollständig mittels der zweiten epitaktischen Schicht (8) überwachsen werden.

3. Verfahren nach Anspruch 1,
**dadurch gekennzeichnet, dass**
die Nanopartikel (6) nur teilweise mittels der zweiten epitaktischen Schicht (8) überwachsen werden.

4. Verfahren nach Anspruch 1, 2 oder 3,
**dadurch gekennzeichnet, dass**
eine Trägerlösung (5) mit einer derartigen Dichte und Viskosität verwendet wird, dass die Nanopartikel (6) in derselben isoliert voneinander in einem schwebenden Zustand gehalten werden.

5. Verfahren nach einem der Ansprüche 1 bis 4,
**dadurch gekennzeichnet, dass**
eine Trägerlösung (5) verwendet wird, durch welche die Oberfläche (4) der ersten epitaktischen Schicht (3) vollständig benetzt wird.

6. Verfahren nach einem der Ansprüche 1 bis 5,
**dadurch gekennzeichnet, dass**
eine Trägerlösung (5) verwendet wird, welche eine derartige chemische Reinheit und einen derartigen Dampfdruck aufweist, dass die Trägerlösung (5) rückstandsfrei von der Oberfläche (4) der ersten epitaktischen Schicht (3) verdampft.

7. Verfahren nach einem der Ansprüche 1 bis 6,
**dadurch gekennzeichnet, dass**
Nanopartikel (6) aus einem halbleitenden, metallischen oder nicht leitenden Material verwendet werden.

8. Verfahren nach einem der Ansprüche 1 bis 7,
**dadurch gekennzeichnet, dass**
Nanopartikel (6) mit einer kugelförmigen, stabförmigen und/oder pyramidalen morphologischen Form verwendet werden.

9. Verfahren nach einem der Ansprüche 1 bis 8,
**dadurch gekennzeichnet, dass**
Nanopartikel (6) mit einer kubischen, hexagonalen, tetragonalen, rhombischen und/oder monoklinen Kristallstruktur verwendet werden.

10. Verfahren nach einem der Ansprüche 1 bis 9,
**dadurch gekennzeichnet, dass**
in die Trägerlösung (5) 1 bis 10¹⁵ Nanopartikel (6) pro cm³ der Trägerlösung (5) eingebracht werden.

11. Verfahren nach einem der Ansprüche 1 bis 10,
**dadurch gekennzeichnet, dass**
aus Silizium, Germanium, A3-B5, A2-B6 oder A4-B6-Verbindungshalbleitern bestehende Nanopartikel (6) verwendet werden.

12. Verfahren nach einem der Ansprüche 1 bis 11,
**dadurch gekennzeichnet, dass**
Nanopartikel (6) mit einer mittleren Größe von 1 - 1000 nm verwendet werden.

13. Verfahren nach einem der Ansprüche 1 bis 12,
**dadurch gekennzeichnet, dass**
als Monomere, Dimere oder Trimere vorliegende Nanopartikel (6) verwendet werden.

14. Verfahren nach einem der Ansprüche 1 bis 13,
**dadurch gekennzeichnet, dass**
die zweite epitaktische Schicht (8) aus Silizium, Germanium, A3-B5, A2-B6 oder A4-B6- Verbindungshalbleitern oder aus metallischen Elementen, Legierungen oder Mischkristallen oder aus nichtleitenden, dielektrischen Materialien besteht.

15. Verfahren nach einem der Ansprüche 1 bis 14,
**dadurch gekennzeichnet, dass**
die erste epitaktische Schicht (3) in Richtung niedrig indizierter kristallographischer Orientierungen gewachsen wird.

16. Verfahren nach einem der Ansprüche 1 bis 14,
**dadurch gekennzeichnet, dass**
die erste epitaktische Schicht (3) mit einer vicinalen Oberflächenorientierung mit einem Winkel von 2 - 10° gewachsen wird.

17. Verfahren nach einem der Ansprüche 1 bis 16,
**dadurch gekennzeichnet, dass**
in die erste epitaktische Schicht (3) wenigstens eine laterale Strukturierung mit einer charakteristischen Strukturierungslänge von 500 nm - 5000 nm eingebracht wird.

18. Verfahren nach einem der Ansprüche 1 bis 17,
**dadurch gekennzeichnet, dass**
die erste epitaktische Schicht (3) mit einer definierten, durch ein Substrat mit abweichender Gitterkonstante aufgeprägten hydrostatischen Verspannung erzeugt wird.

19. Verfahren nach einem der Ansprüche 1 bis 18,
**dadurch gekennzeichnet, dass**
die Trägerlösung (5) durch Auftropfen oder Spinnen oder Aufsprühen auf die Oberfläche (4) der ersten epitaktischen Schicht (3) aufgebracht wird.

20. Verfahren nach einem der Ansprüche 1 bis 19,
**dadurch gekennzeichnet, dass**
die Nanopartikel (6) mit einer derartigen Dichte auf die Oberfläche (4) der ersten epitaktischen Schicht (3) aufgebracht werden, dass der Abstand der voneinander benachbarten Nanopartikel (6) im Bereich ihres Durchmessers liegt.

21. Verfahren nach Anspruch 20,
**dadurch gekennzeichnet, dass**
die Nanopartikel (6) vor dem epitaktischen Überwachsen mit der zweiten epitaktischen Schicht (8) durch thermische Aktivierung und/oder hydrostatische Verspannung in einen lateral geordneten Zustand gebracht werden.

22. Verfahren nach Anspruch 20 oder 21,
**dadurch gekennzeichnet, dass**
die Nanopartikel (6) vor dem epitaktischen Überwachsen mit der zweiten epitaktischen Schicht (8) durch rastersondenmikroskopische Verfahren in einen lateral geordneten Zustand gebracht werden.

23. Verfahren nach einem der Ansprüche 1 bis 23,
**dadurch gekennzeichnet, dass**
die Nanopartikel (6) mit einem Material der zweiten epitaktischen Schicht (8) überwachsen werden, welches im wesentlichen die gleiche chemische Zusammensetzung und die gleiche Kristallstruktur wie die Nanopartikel (6) aufweist.

24. Verfahren nach einem der Ansprüche 1 bis 23,
**dadurch gekennzeichnet, dass**
die Nanopartikel (6) mit einem Material der zweiten epitaktischen Schicht (8) überwachsen werden, welches im wesentlichen die gleiche chemische Zusammensetzung und eine unterschiedliche Kristallstruktur wie die Nanopartikel (6) aufweist.

25. Verfahren nach einem der Ansprüche 1 bis 23,
**dadurch gekennzeichnet, dass**
die Nanopartikel (6) mit einem Material der zweiten epitaktischen Schicht (8) überwachsen werden, welches eine unterschiedliche chemische Zusammensetzung und die gleiche Kristallstruktur wie die Nanopartikel (6) aufweist.

26. Verfahren nach einem der Ansprüche 1 bis 23,
**dadurch gekennzeichnet, dass**
die Nanopartikel (6) mit einem Material der zweiten epitaktischen Schicht (8) überwachsen werden, welches eine unterschiedliche chemische Zusammensetzung und eine unterschiedliche Kristallstruktur wie die Nanopartikel (6) aufweist.

27. Verfahren nach einem der Ansprüche 23 bis 26,
**dadurch gekennzeichnet, dass**
die Nanopartikel (6) vor dem Aufbringen auf die Oberfläche (4) der ersten epitaktischen Schicht (3) so modifiziert werden, dass sie Dotierstoffe, insbesondere magnetische Ionen, auf ihrer Oberfläche oder in ihrem Volumen enthalten.

28. Verfahren nach einem der Ansprüche 1 bis 26,
**dadurch gekennzeichnet, dass**
mehrere Schichten von Nanopartikeln (6) und mehrere die Nanopartikel (6) überwachsende Schichten (8,12,13) aufgebracht werden.

29. Elektronisches Bauelement mit einer gemäß einem Verfahren nach einem der Ansprüche 1 bis 27 hergestellten epitaktischen Schichtstruktur.
